(19) Europäisches Patentamt
European Patent Office
Office européen des brevets

(11) EP 0 512 339 B1

(12) # EUROPÄISCHE PATENTSCHRIFT

(45) Veröffentlichungstag und Bekanntmachung des Hinweises auf die Patenterteilung:
**15.10.1997 Patentblatt 1997/42**

(51) Int Cl.[6]: **G03F 7/023**

(21) Anmeldenummer: **92107063.7**

(22) Anmeldetag: **24.04.1992**

(54) **Hochwärmebeständige Positivresists und Verfahren zur Herstellung hochwärmebeständiger Reliefstrukturen**

High temperature stable positive resists and process for the production of high temperature stable relief structure

Réserve positive stable à haute température et procédé d'obtention de structures en relief stables à la chaleur

(84) Benannte Vertragsstaaten:
**BE DE FR GB NL**

(30) Priorität: **07.05.1991 DE 4114928**

(43) Veröffentlichungstag der Anmeldung:
**11.11.1992 Patentblatt 1992/46**

(73) Patentinhaber: **SIEMENS AKTIENGESELLSCHAFT**
**80333 München (DE)**

(72) Erfinder:
- **Hammerschmidt, Albert, Dr.**
  **W-8529 Erlangen (DE)**
- **Birkle, Siegfried, Dr.**
  **W-8552 Höchstadt/Aisch (DE)**
- **Ahne, Hellmut, Dr.**
  **W-8551 Röttenbach (DE)**

(56) Entgegenhaltungen:
**EP-A- 0 450 189**
**DE-A- 3 716 629**
**FR-A- 2 628 112**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).



Printed by Jouve, 75001 PARIS (FR)

**Beschreibung**

Die Erfindung betrifft hochwärmebeständige Positivresists auf der Basis von oligomeren und/oder polymeren Polybenzoxazol-Vorstufen und Diazochinonen sowie ein Verfahren zur Herstellung hochwärmebeständiger Reliefstrukturen aus derartigen Positivresists.

In hochtemperaturbeständigen Photoresists, die für eine kostengünstige direkte Strukturierung organischer Isolierschichten benötigt werden, dienen Hydroxypolyamide als lösliche Polybenzoxazol-Vorstufen. Die aus den Hydroxypolyamiden erhaltenen Polybenzoxazole zeichnen sich durch eine hohe Temperaturbeständigkeit und eine geringe Wasseraufnahme sowie durch hervorragende elektrische Eigenschaften aus. Die Polybenzoxazole können als Ätzmasken, vor allem bei alkalischen Ätzprozessen, und auch als organische Dielektrika in der Halbleiterfertigung dienen.

Photostrukturierbare Polybenzoxazol-Vorstufen können sowohl in Positiv- als auch in Negativresists Verwendung finden. Die Positivresists enthalten dabei neben der Polymer-Vorstufe eine photoaktive Komponente in Form von Diazochinon (siehe dazu: EP-PS 0 023 662, EP-OS 0 291 779 und DE-OS 37 16 629), während die Negativresists Polymer-Vorstufen mit vernetzbaren ungesättigten Gruppen aufweisen (siehe dazu: EP-PS 0 041 677).

Bei beiden der genannten Resisttypen können allerdings Probleme bei der Lagerstabilität auftreten. Bei Hydroxypolyamide enthaltenden Positivresists kann in konzentrierten Resistlösungen eine Polykondensation erfolgen; Negativresists neigen infolge der Anwesenheit von ungesättigten Gruppen, wie Acryl- und Methacrylgruppen, zur Polymerisation. Bei beiden Resisttypen führt dies zu einer Viskositätserhöhung, bis hin zur Gelbildung. Bei Positivresists kann darüber hinaus die photoaktive Komponente durch basische Aminoendgruppen bzw. durch Aminmonomere und Amidoligomere zerstört werden.

Aufgabe der Erfindung ist es, kostengünstige hochwärmebeständige Positivresists auf der Basis von oligomeren und/oder polymeren Polybenzoxazol-Vorstufen und Diazochinonen anzugeben, bei denen die bislang mit derartigen Resists verbundenen Schwierigkeiten hinsichtlich der Lagerstabilität nicht auftreten. Dabei sollen die Resistlösungen nicht nur ausreichend lagerstabil sein, sondern auch Reliefstrukturen mit einer Formbeständigkeit > 400°C ergeben.

Dies wird erfindungsgemäß dadurch erreicht, daß die Polybenzoxazol-Vorstufen Hydroxypolyamide folgender Struktur sind:

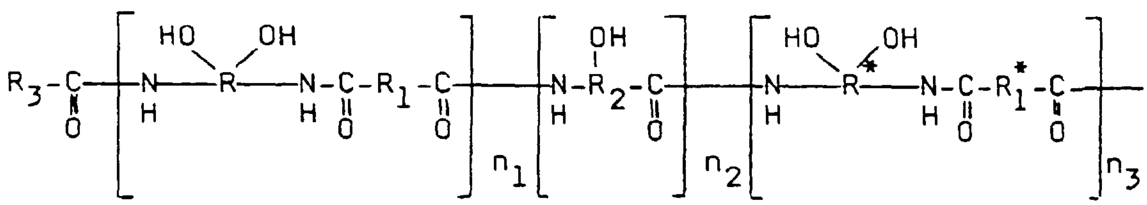
,

wobei R, R*, $R_1$, $R_1^*$ und $R_2$ aromatische Gruppen sind, $R_3$ eine aliphatische, cycloaliphatische oder aromatische Gruppe mit mindestens einer Alkenyl- oder Alkinylgruppierung ist, und bezüglich $n_1$, $n_2$ und $n_3$ folgendes gilt:

$n_1$ = 1 bis 100, $n_2$ und $n_3$ = 0 oder
$n_1$ und $n_2$ = 1 bis 100, $n_3$ = 0 oder
$n_2$ = 1 bis 100, $n_1$ und $n_3$ = 0 oder
$n_1$, $n_2$ und $n_3$ = 1 bis 100 (mit $R \neq R^*$ und/oder $R_1 \neq R_1^*$) oder
$n_1$ und $n_3$ = 1 bis 100, $n_2$ = 0 (mit $R \neq R^*$ und/oder $R_1 \neq R_1^*$), mit der Maßgabe: $n_1 + n_2 + n_3 \geq 3$.

Die Polybenzoxazol-Vorstufen, welche in den erfindungsgemäßen Positivresists zum Einsatz gelangen, sind Hydroxypolyamide mit einer speziellen Struktur. Bei diesen Hydroxypolyamiden sind nämlich die ansonsten üblicherweise vorhandenen Aminoendgruppen in ganz bestimmter Weise modifiziert. Die Modifizierung der Aminoendgruppen führt nun aber zu Polybenzoxazol-Vorstufen, die - hinsichtlich Viskosität und Beständigkeit der Resistlösungen - lagerstabile Positivresists mit Diazochinonen als photoaktive Komponente ergeben. Aus derartigen lagerstabilen Positivresists lassen sich - auf photolithographischem Weg - überraschenderweise Reliefstrukturen erzeugen, welche beim Tempern bis Temperaturen > 400°C formstabil sind.

Für die Hydroxypolyamide der vorstehend genannten Art gilt im allgemeinen folgendes.

R und R* können folgende Bedeutung haben:

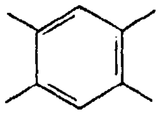 , 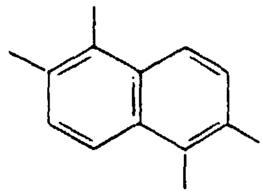 , 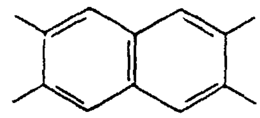 ,

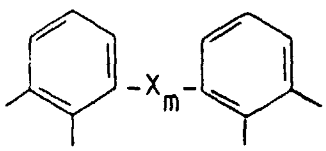 , 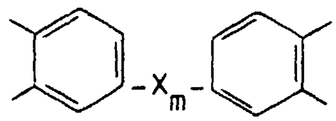 ,

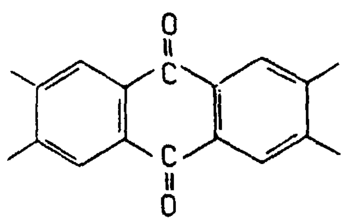 , 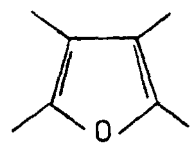 , 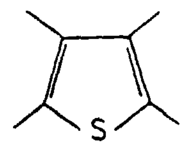

und

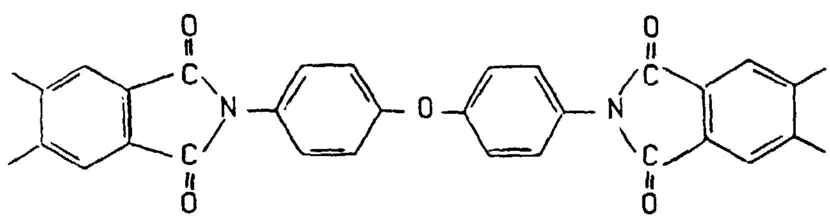 .

$R_1$ und $R_1^*$ können folgende Bedeutung haben, wobei H-Atome auch durch Cl oder Br substituiert sein können:

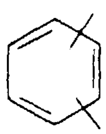 , 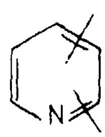 , 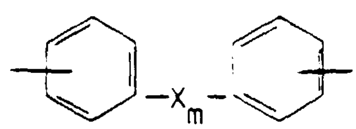 und 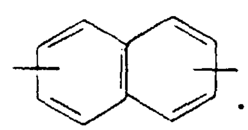 .

$R_2$ kann folgende Bedeutung haben:

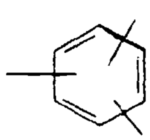 , 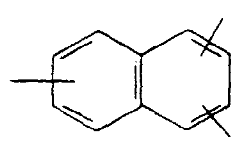 und 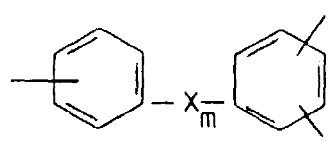 ;

die aromatischen Reste können dabei auch Alkylsubstituenten tragen.

Für m und X gilt dabei folgendes:

m = 0 oder 1, und
X bedeutet:

-O-, 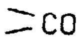, 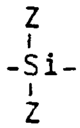, 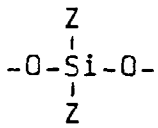, -S-, $-SO_2-$, 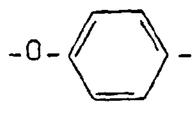, 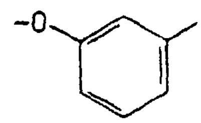,

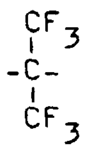, 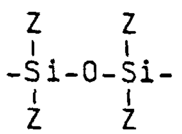, 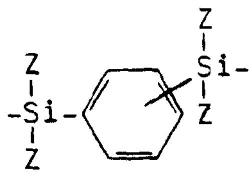, 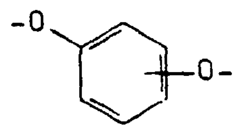, 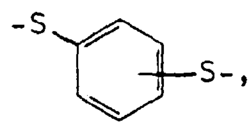,

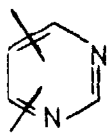 und $-(CF_2)_r-$ ;

dabei gilt folgendes:

Z = Alkyl mit 1 bis 10 Kohlenstoffatomen oder Aryl, und
r = 2 bis 18.

$R_3$ kann folgende Bedeutung haben:

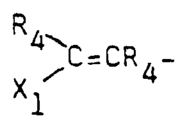

oder $-C(R_4)_2-M_X-(CH_2)_y-M_X-Q-(CH_2)_y-H$ oder

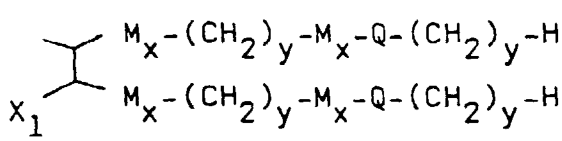

mit

$X_1$ = H, Alkyl oder COOH,
M = O oder S,
Q = -C≡C- oder $-CR_4=CR_4-$,
$R_4$ = H oder Alkyl,
x = 0 oder 1,
y = 0, 1, 2 oder 3;

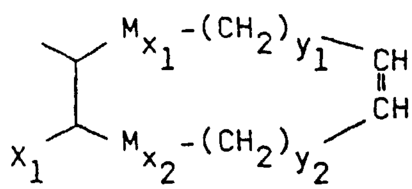

oder

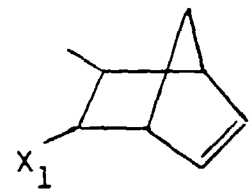

mit

$X_1$ = H, Alkyl oder COOH,
M = O oder S,
$x_1$ und $x_2$ = 0 oder 1,
$y_1$ und $y_2$ = 0, 1, 2 oder 3,

wobei folgendes gilt:

$$x_1 + x_2 + y_1 + y_2 \leq 4,$$

$$y_1 + y_2 \geq 1;$$

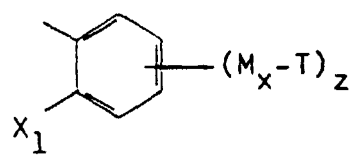

mit

$X_1$ = H, Alkyl oder COOH,
M = O oder S,
T = $(CH_2)_y$-$M_x$-CH=CH-$(CH_2)_y$-H'
x = 0 oder 1,
y = 0, 1, 2 oder 3,
z = 1 oder 2.

Für die Hydroxypolyamide dienen als Basismaterialien Polykondensationsprodukte, und zwar

- Co-Polykondensationsprodukte aus aromatischen Diaminodihydroxyverbindungen und aromatischen Dicarbonsäuren bzw. Dicarbonsäurechloriden;
- Homo-Polykondensationsprodukte aromatischer Aminohydroxycarbonsäuren;
- Co-Polykondensationsprodukte aus aromatischen Diaminodihydroxyverbindungen, aromatischen Dicarbonsäuren bzw. Dicarbonsäurechloriden und aromatischen Aminohydroxycarbonsäuren.

Vorzugsweise werden Hydroxypolyamide folgender Art eingesetzt:

- Polykondensationsprodukte aus 3,3'-Dihydroxybenzidin und Isophthalsäuredichlorid;
- Polykondensationsprodukte aus 3,3'-Dihydroxybenzidin, 2,2-Bis(3-amino-4-hydroxyphenyl)-1,1,1,3,3,3-hexafluorpropan und Isophthalsäuredichlorid;
- Polykondensationsprodukte von 3-Amino-4-hydroxybenzoesäure.

Als Diaminodihydroxyverbindungen können - neben 3,3'-Dihydroxybenzidin (3,3'-Dihydroxy-4,4'-diaminobiphenyl) - auch Isomere dieser Verbindung eingesetzt werden und auch andere hydroxylgruppenhaltige aromatische Diamine, wie 3,3'-Dihydroxy-4,4'-diaminodiphenylether. Neben Isophthalsäuredichlorid kann - als Dicarbonsäure - auch Isophthalsäure verwendet werden. Als Dicarbonsäure kann aber auch Terephthalsäure und als Dicarbonsäurederivat Terephthalsäuredichlorid dienen.

Die Basismaterialien weisen Aminoendgruppen auf, die noch modifiziert werden, und zwar in der Weise, daß die Aminogruppen in Säureamidgruppen (von ungesättigten aliphatischen, cycloaliphatischen oder aromatischen Carbonsäuren) übergeführt werden. Die Modifizierung erfolgt derart, daß die Aminoendgruppen mit geeigneten Carbonsäurederivaten, insbesondere Carbonsäurechloriden und Dicarbonsäureanhydriden, zur Reaktion gebracht werden. Dabei wird zweckmäßig in der Weise vorgegangen, daß bei der Herstellung der Hydroxypolyamide mit einem Unterschuß an Dicarbonsäure bzw. Dicarbonsäurechlorid gearbeitet wird (zur Herstellung selbst siehe beispielsweise EP-OS 0 391 196) und die dabei verbleibenden freien Aminogruppen dann mit dem Derivat der ungesättigten Carbonsäure umgesetzt werden. Insbesondere beim Einsatz von Säurechloriden ist dabei erforderlich, die Umsetzung so zu führen, daß das Carbonsäurederivat mit den Aminogruppen und nicht mit den Hydroxylgruppen (der Hydroxypolyamide) reagiert. Dazu wird das Carbonsäurederivat langsam zu der Reaktionslösung getropft, und die Reaktion wird erforderlichenfalls bei niedrigen Temperaturen, d.h. bei etwa 0°C oder darunter, durchgeführt.

Geeignete Verbindungen zur Modifizierung der Aminoendgruppen (der Hydroxypolyamide) sind beispielsweise Maleinsäureanhydrid, Norbornendicarbonsäureanhydrid und 4-Vinyl-benzoesäurechlorid. Der Vorteil bei der Verwendung von Derivaten ungesättigter Carbonsäuren besteht dabei darin, daß beim Temperprozeß zusätzliche Vernetzungsreaktionen erfolgen. Beim Einsatz cyclischer Carbonsäureanhydride, wie Maleinsäure- und Norbornendicarbonsäureanhydrid, ergibt sich der weitere Vorteil, daß beim Tempern ein Imid mit einer benachbarten Hydroxylgruppe entsteht, welche ebenfalls vernetzen kann bzw. die Haftung verbessert.

Als photoaktive Komponente gelangen in den erfindungsgemäßen Positivresists an sich bekannte lichtempfindliche Diazochinone zum Einsatz, insbesondere o-Chinon- und o-Naphthochinondiazide (siehe dazu EP-PS 0 023 662). Vorzugsweise werden Ester oder Amide der 6-Diazo-5(6)-oxo-1-naphthalinsulfonsäure verwendet, insbesondere der Bis-naphthochinon-[1,2]-diazid-(2)-5-sulfonsäureester von β,β-Bis(4-hydroxyphenyl-propan. Das Masseverhältnis von Hydroxypolyamid zu Diazochinon beträgt dabei vorteilhaft 1:20 bis 20:1, vorzugweise 1:10 bis 10:1.

Zur Herstellung hochwärmebeständiger Reliefstrukturen wird ein erfindungsgemäßer Positivresist in Form einer Schicht oder Folie auf ein Substrat aufgebracht und mit aktinischem Licht durch eine Maske belichtet oder durch Führen eines Licht-, Elektronen- oder Ionenstrahls bestrahlt. Anschließend werden die belichteten bzw. bestrahlten Schicht- oder Folienteile herausgelöst oder abgezogen, und die dabei erhaltenen Reliefstrukturen werden dann getempert.

Der Photoresist kann vorteilhaft in einem organischen Lösungsmittel gelöst auf das Substrat aufgebracht werden. Als Lösungsmittel wird dabei vorzugsweise N-Methylpyrrolidon verwendet. Daneben können aber auch andere organische Lösungsmittel mit ähnlichen Eigenschaften zum Einsatz gelangen, wie Dimethylformamid und N.N-Dimethylacetamid, sowie Gemische der genannten Lösungsmittel.

Bei der Herstellung der Reliefstrukturen kann vorteilhaft ein Haftvermittler und/oder ein Benetzungsmittel verwendet werden. Haftvermittler bzw. Benetzungsmittel können dabei der Polymerlösung zugesetzt werden, sie können aber auch - vor der Beschichtung - auf das Substrat aufgebracht werden. Die Polymerlösung wird vorzugsweise mittels Schleudertechnik sowie Tauch- oder Sprühverfahren auf das Substrat aufgebracht. Daneben können aber auch andere Beschichtungsmethoden, wie Bürsten und Rollen, angewendet werden. Das Substrat besteht vorzugsweise aus Glas, aus Metall, insbesondere Aluminium, aus Kunststoff oder aus einem halbleitenden Material.

Die Umwandlung der strukturierten Polymerschichten in hochwärmebeständige Polybenzoxazole erfolgt durch einen Temperprozeß. Im allgemeinen werden dabei Temperaturen zwischen 200 und 500°C gewählt. Vorzugsweise erfolgt die Temperung bei einer Temperatur zwischen 300 und 400°C. Auf diese Weise werden dielektrisch hochwertige Polybenzoxazole mit guten filmbildenden Eigenschaften erhalten, insbesondere auch solche mit Hexafluorpropyl-Partialstrukturen.

Anhand von Ausführungsbeispielen soll die Erfindung noch näher erläutert werden.

1. Herstellung eines Hydroxypolyamids

105 Masseteile 2,2-Bis(3-amino-4-hydroxyphenyl)-1,1,1,3,3,3-hexafluorpropan und 62 Masseteile 3,3'-Dihydroxybenzidin werden unter Argon in 1380 Masseteilen N,N-Dimethylacetamid und 250 Masseteilen Pyridin gelöst. Zu der auf 0°C abgekühlten Lösung werden dann unter starkem Rühren 104 Masseteile Isophthalsäuredichlorid, gelöst in 460 Masseteilen Cyclohexanon, zugetropft. Nach 2 1/2stündigem Rühren läßt man die Reaktionsmischung auf Raumtemperatur erwärmen und rührt weitere 3 1/2 h. Nach 12stündigem Stehen werden unter Rühren langsam 37,1 Masseteile Norbornendicarbonsäureanhydrid zugetropft, dann läßt man für 12 h bei Raumtemperatur stehen. Anschließend wird die Reaktionslösung in 18 l Wasser getropft, das dabei ausfallende Polymere wird dann gewaschen und im Vakuumtrockenschrank über NaOH getrocknet.

2. Reinigung des Hydroxypolyamids

Das nach Beispiel 1 hergestellte Hydroxypolyamid wird mittels Ionenaustauschern gereinigt. Dazu werden 150 Masseteile eines handelsüblichen Anionenaustauschers in destilliertem Wasser aufgeschlämmt, in eine Chromatographiesäule gefüllt und neutral gewaschen; anschließend wird das Wasser durch N-Methylpyrrolidon ersetzt. In entsprechender Weise werden 100 Masseteile eines handelsüblichen Kationenaustauschers in destilliertem Wasser aufgeschlämmt, in eine Chromatographiesäule gefüllt und solange mit 10 %iger HCl gewaschen, bis das Eluat sauer reagiert; anschließend wird mit Wasser neutral und chloridfrei gewaschen und das Wasser dann durch N-Methylpyrrolidon ersetzt.

Zur Reinigung werden 200 Masseteile getrocknetes Hydroxypolyamid in 2000 Masseteilen N-Methylpyrrolidon gelöst, und die Lösung wird dann auf den Anionen- und den Kationenaustauscher gegeben. Die auf diese Weise gereinigte Polymerlösung wird zu ca. 17 l Wasser getropft, das dabei ausfallende Polymere isoliert, gewaschen und im Vakuumtrockenschrank über NaOH getrocknet.

In der vorstehend beschriebenen Weise hergestellte Lösungen von Polybenzoxazol-Vorstufen in Form endgruppenmodifizierter Hydroxypolyamide zeichnen sich gegenüber Lösungen entsprechender nicht-endgruppenmodifizierter Hydroxypolyamide durch eine besonders gute Viskositätsstabilität aus.

3. Herstellung einer Resistlösung

15 Masseteile einer in der vorstehend beschriebenen Weise hergestellten und gereinigten Polybenzoxazol-Vorstufe werden zu einer Lösung von 3 Masseteilen Bis-naphthochinon-[1,2]-diazid-(2)-5-sulfonsäureester von β,β-Bis (4-hydroxyphenyl)-propan in 65 Masseteilen N-Methylpyrrolidon gegeben; die dabei erhaltene Lösung wird dann durch ein 0,8 µm-Filter druckfiltriert.

Eine derartige Lösung erweist sich als lagerstabil und zwar sowohl hinsichtlich der Viskosität der Lösung als auch hinsichtlich der technologischen Eigenschaften.

4. Herstellung einer Reliefstruktur

Auf eine Siliciumscheibe wird zunächst ein Haftvermittler aufgebracht (5000 U/min - 30 s; 80°C - 10 min). Dann wird die Siliciumscheibe mittels eines Schleuderverfahrens (3000 U/min - 20 s) mit einer entsprechend Beispiel 3 hergestellten photoreaktiven Lösung beschichtet und dann wird getrocknet (Schichtdicke: 1,6 µm). Anschließend wird 6 bis 7 s durch eine Maske belichtet (MJP 55: 23 mW/$cm^2$, gemessen mit OAI 400 nm), mit einem MIF-Entwickler NMD-3 (0,32 %ig) entwickelt und dann im Diffusionsofen unter Stickstoff getempert (Temperprogramm: Raumtemperatur bis 170°C: 1 h, 170 bis 300°C: 1 h, 300 bis 400°C: l h, 400°C: l h, 400°C bis Raumtemperatur: 4 h).

Dabei entstehen feine wärmeformbeständige Reliefstrukturen mit einer Auflösung < 1,6 µm.

## Patentansprüche

**1.** Hochwärmebeständige Positivresists auf der Basis von oligomeren und/oder polymeren Polybenzoxazol-Vorstufen und Diazochinonen, **dadurch gekennzeichnet**, daß die Polybenzoxazol-Vorstufen Hydroxypolyamide folgender Struktur sind:

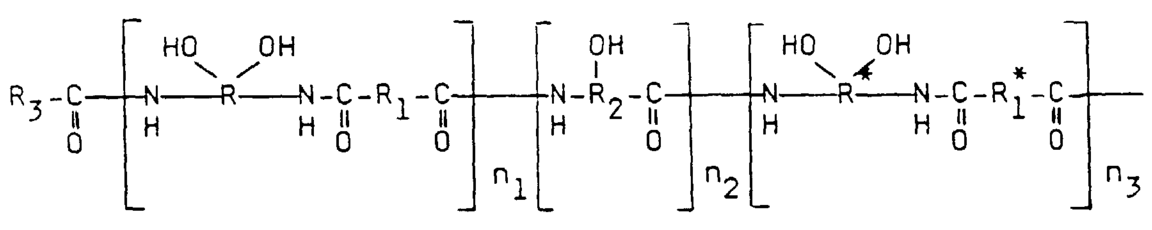 ,

wobei $R$, $R^*$, $R_1$, $R_1^*$ und $R_2$ aromatische Gruppen sind, $R_3$ eine aliphatische, cycloaliphatische oder aromatische Gruppe mit mindestens einer Alkenyl- oder Alkinylgruppierung ist, und bezüglich $n_1$, $n_2$ und $n_3$ folgendes gilt:

$n_1$ = 1 bis 100, $n_2$ und $n_3$ = 0 oder
$n_1$ und $n_2$ = 1 bis 100, $n_3$ = 0 oder
$n_2$ = 1 bis 100, $n_1$ und $n_3$ = 0 oder

$n_1$, $n_2$ und $n_3$ = 1 bis 100 (mit $R \neq R^*$ und/oder $R_1 \neq R_1^*$) oder
$n_1$ und $n_3$ = 1 bis 100, $n_2$ = 0 (mit $R \neq R^*$ und/oder $R_1 \neq R_1^*$), mit der Maßgabe: $n_1 + n_2 + n_3 \geq 3$.

**2.** Positivresists nach Anspruch 1, **dadurch gekennzeichnet**, daß das Diazochinon ein Ester oder ein Amid der 6-Diazo-5(6)-oxo-1-naphthalinsulfonsäure ist.

**3.** Positivresists nach Anspruch 1 oder 2, **dadurch gekennzeichnet**, daß das Masseverhältnis von Hydroxypolyamid zu Diazochinon 1:20 bis 20:1, vorzugsweise 1:10 bis 10:1, beträgt.

**4.** Verfahren zur Herstellung hochwärmebeständiger Reliefstrukturen, **dadurch gekennzeichnet**, daß ein Positivresist nach einem der Ansprüche 1 bis 3 in Form einer Schicht oder Folie auf ein Substrat aufgebracht und mit aktinischem Licht durch eine Maske belichtet oder durch Führen eines Licht-, Elektronen- oder Ionenstrahls bestrahlt wird, und daß die belichteten bzw. bestrahlten Schicht- oder Folienteile herausgelöst oder abgezogen und die dabei erhaltenen Reliefstrukturen getempert werden.

**5.** Verfahren nach Anspruch 4, **dadurch gekennzeichnet,** daß der Positivresist in einem organischen Lösungsmittel gelöst auf das Substrat aufgebracht wird.

**6.** Verfahren nach Anspruch 5, **dadurch gekennzeichnet,** daß als Lösungsmittel N-Methylpyrrolidon verwendet wird.

**7.** Verfahren nach Anspruch 5 oder 6, **dadurch gekennzeichnet,** daß die Lösung mittels Schleudertechnik auf das Substrat aufgebracht wird.

**8.** Verfahren nach einem der Ansprüche 4 bis 7, **dadurch gekennzeichnet,** daß ein Substrat aus Glas, Kunststoff, halbleitendem Material oder Metall, insbesondere Aluminium, verwendet wird.

**9.** Verfahren nach einem oder mehreren der Ansprüche 4 bis 8, **dadurch gekennzeichnet,** daß ein Haftvermittler und/oder ein Benetzungsmittel verwendet wird.

**10.** Verfahren nach einem oder mehreren der Ansprüche 4 bis 9, **dadurch gekennzeichnet,** daß bei einer Temperatur zwischen 200 und 500°C, vorzugsweise zwischen 300 und 400°C, getempert wird.

**Claims**

**1.** High-temperature-resistant positive resists based on oligomeric and/or polymeric polybenzoxazole precursors and diazoquinones, characterised in that the polybenzoxazole precursors are hydroxypolyamides having the following structure:

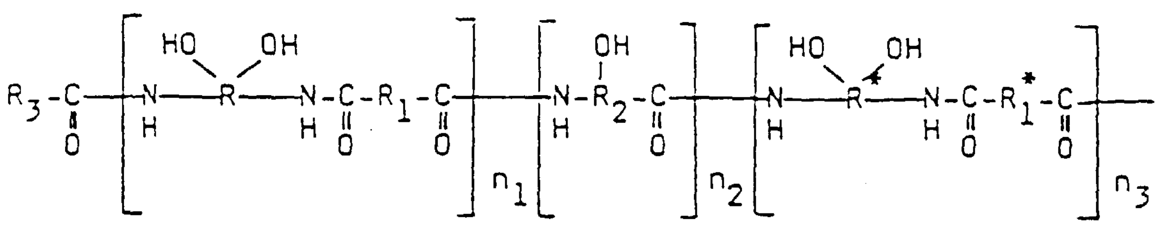
,

where R, $R^*$, $R_1$, $R_1^*$ and $R_2$ are aromatic groups, $R_3$ is an aliphatic, cycloaliphatic or aromatic group having at least one alkenyl grouping or alkinyl grouping, and with regard to $n_1$, $n_2$ and $n_3$, the following applies:

$n_1$ = 1 to 100, $n_2$ and $n_3$ = 0 or
$n_1$ and $n_2$ = 1 to 100, $n_3$ = 0 or
$n_2$ = 1 to 100, $n_1$ and $n_3$ = 0 or
$n_1$, $n_2$ and $n_3$ = 1 to 100 (with $R \neq R^*$ and/or $R_1 \neq R_1^*$) or
$n_1$ and $n_3$ = 1 to 100, $n_2$ = 0 (with $R \neq R*$ and/or $R_1 \neq R_1^*$), with the scale: $n_1 + n_2 + n_3 \geq 3$.

2. Positive resists according to claim 1, characterised in that the diazoquinone is an ester or an amide of the 6-diazo-5(6)-oxo-1-naphthalenesulphonic acid.

3. Positive resists according to claim 1 or 2, characterised in that the mass ratio of hydroxypolyamide to diazoquinone amounts to 1:20 to 20:1, preferably 1:10 to 10:1.

4. Method for preparing high-temperature-resistant relief structures, characterised in that a positive resist according to one of the claims 1 to 3 is applied in the form of a layer or a film to a substrate and is exposed to actinic light through a mask or irradiated by guiding a light beam, electron beam or ionic beam, and in that the exposed or irradiated layer portions or film portions are then dissolved away or drawn off and the relief structures which are obtained thereby are tempered.

5. Method according to claim 4, characterised in that the positive resist dissolved in an organic solvent is applied to the substrate.

6. Method according to claim 5, characterised in that N-methylpyrrolidone is used as a solvent.

7. Method according to claim 5 and 6, characterised in that the solution is applied to the substrate by means of centrifugal technology.

8. Method according to one of the claims 4 to 7, characterised in that a substrate made of glass, plastics, semiconducting material or metal, in particular aluminium, is used.

9. Method according to one or more of the claims 4 to 8, characterised in that an adhesion promoter and/or a wetting agent is used.

10. Method according to one or more of the claims 4 to 9, characterised in that the tempering is carried out at a temperature of between 200 and 500°C, preferably between 300 and 400°C.

## Revendications

1. Réserves positives stables à haute température à base de précurseurs polybenzoxazol oligomères et/ou polymères et de diazoquinones, caractérisées en ce que les précurseurs polybenzoxazol sont des hydroxypolyamides de structure :

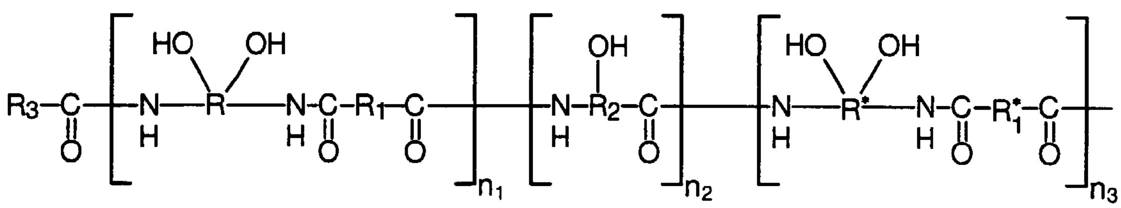

,

où R, R*, $R_1$, $R^*_1$ et $R_2$ sont des groupes aromatiques, $R_3$ est un groupe aliphatique, aliphatique cyclique ou aromatique avec au moins un groupe alcényle ou alcynyle et où $n_1$, $n_2$ et $n_3$ sont :

$n_1$ = 1 à 100, $n_2$ et $n_3$ = 0 ou
$n_1$ et $n_2$ = 1 à 100, $n_3$ = 0 ou
$n_2$ = 1 à 100, $n_1$ et $n_3$ = 0 ou
$n_1$, $n_2$ et $n_3$ = 1 à 100 (avec R ≠ R* et/ou $R_1 \neq R_1$*) ou
$n_1$ et $n_3$ = 1 à 100, $n_2$ = 0 (avec R ≠ R* et/ou $R_1 \neq R_1$*),

avec cette mesure que : $n_1 + n_2 + n_3 \geq 3$.

2. Réserve positive selon la revendication 1, caractérisée en ce que la diazoquinone est un ester ou un amide de l'acide 6-diazo-5(6)-oxo-1-naphtalènesulfonique.

3. Réserve positive selon la revendication 1 ou 2, caractérisée en ce que le rapport massique entre l'hydroxypolyamide et la diazoquinone est compris entre 1:20 et 20:1, de préférence entre 1:10 et 10:1.

4. Procédé d'obtention de structures en relief stables à haute température, caractérisé en ce qu'une réserve positive selon l'une des revendications 1 à 3 est déposée sous forme de couche ou de feuille sur un substrat et éclairée par une lumière actinique à travers un masque ou irradiée en guidant un faisceau de lumière, d'électrons ou d'ions et en ce que les parties éclairées respectivement irradiées de la couche ou de la feuille sont détachées ou retirées et en ce que les structures en relief ainsi obtenues sont recuites.

5. Procédé selon la revendication 4, caractérisé en ce que la réserve positive est dissoute dans un solvant organique et déposée sur le substrat.

6. Procédé selon la revendication 5, caractérisé en ce que le solvant utilisé est la N-méthylpyrrolidone.

7. Procédé selon la revendication 5 ou 6, caractérisé en ce que la solution est déposée sur le substrat au moyen d'une technique centrifuge.

8. Procédé selon l'une des revendications 4 à 7, caractérisé en ce qu'il est utilisé un substrat en verre, en matière plastique, en matière semi-conductrice ou en métal, en particulier l'aluminium.

9. Procédé selon l'une ou plusieurs des revendications 4 à 8, caractérisé en ce qu'un intermédiaire collant et/ou un agent mouillant est utilisé.

10. Procédé selon l'une ou plusieurs des revendications 4 à 9, caractérisé en ce que le recuit est effectué à une température comprise entre 200 et 500°C, préférentiellement entre 300 et 400°C.